# FASCICULE DE BREVET EUROPEEN

(11) **EP 3 961 923 B1**
(45) Date de publication et mention de la délivrance du brevet: **04.03.2026**
(21) Numéro de dépôt: 21193884.0
(22) Date de dépôt: 30.08.2021
(51) Int. Cl.: H03K 3/356

(54) **DISPOSITIF ET PROCÉDÉ DE DÉCALAGE DE NIVEAU**
PEGELVERSCHIEBUNGSVORRICHTUNG UND -VERFAHREN
DEVICE AND METHOD FOR LEVEL SHIFT

(30) Priorité: 31.08.2020 FR 2008826
(43) Date de publication de la demande: 02.03.2022
(73) Titulaire: STMICROELECTRONICS (GRENOBLE 2) SAS, 38000 Grenoble (FR)
(72) Inventeur: COTTIN, Denis, 38920 CROLLES (FR); ROMAIN, Fabrice, 38340 VOREPPE (FR)
(74) Mandataire: Cabinet Beaumont

(56) Documents cités:
- FR-A1- 2 797 118
- US-A- 5 204 557
- US-A- 5 559 464
- US-A1- 2007 085 566
- US-A1- 2014 306 684

## Description

### Domaine technique

La présente description concerne de façon générale les dispositifs électroniques tels que les circuits intégrés, en particulier les dispositifs de décalage de niveau logique ou translateurs de niveau logique (en anglais "level shifter").

### Technique antérieure

Un translateur de niveau logique est un circuit prévu pour recevoir un signal logique d'entrée, et fournir un signal logique de sortie représentatif du signal logique d'entrée, le signal logique de sortie ayant des niveaux de potentiel pouvant être différents de ceux du signal d'entrée. Les niveaux de potentiel d'un signal logique correspondent aux états logiques respectifs, par exemple zéro et un, ou bas et haut, de ce signal logique. Autrement dit, le niveau de chacun des signaux logiques d'entrée et sortie est parmi deux niveaux de potentiel.

Pour l'un des niveaux d'entrée, le translateur de niveau met le potentiel de sortie à l'un des niveaux de sortie, et, pour l'autre des niveaux d'entrée, le translateur de niveau met le potentiel de sortie à l'autre des niveaux de sortie. Autrement dit, le translateur de niveau logique sélectionne le niveau de potentiel de sortie parmi les deux niveaux de sortie, différent des deux niveaux d'entrée, en fonction du niveau pris par le signal logique d'entrée.

Le document US 5,559,464 décrit un circuit de conversion de niveau de tension.

Le document FR 2 797 118 décrit un dispositif de commande d'un commutateur haute tension de type translateur.

### Résumé de l'invention

Il existe un besoin d'améliorer les translateurs de niveau logique connus et les procédés connus de décalage de niveau logique.

Un mode de réalisation pallie tout ou partie des inconvénients des translateurs de niveau logique connus.

Un mode de réalisation pallie tout ou partie des inconvénients des procédés connus de décalage de niveau logique.

L'invention est définie par les revendications indépendantes 1 et 2.

Un aspect de l'invention prévoit un procédé de fourniture d'un niveau de potentiel de sortie parmi deux premiers niveaux en fonction d'un niveau d'entrée parmi deux deuxièmes niveaux, pour le décalage de niveau logique, comprenant :
- la fourniture du niveau de sortie par un premier nœud connectant entre eux des premier et deuxième transistors électriquement en série entre deux deuxièmes nœuds d'application des premiers niveaux ;
- la fourniture, par un premier générateur de tension alimenté par l'un des deuxièmes nœuds, d'une première tension continue définissant une limite haute de tension de commande du premier transistor ; et
- la fourniture, par un deuxième générateur de tension commandé par une valeur représentative de la première tension et alimenté entre les deuxièmes nœuds, d'une deuxième tension continue définissant une limite haute de tension de commande du deuxième transistor.

Un autre aspect de l'invention prévoit un dispositif de décalage de niveau logique configuré pour fournir un niveau de potentiel de sortie parmi deux premiers niveaux en fonction d'un niveau d'entrée parmi deux deuxièmes niveaux, comprenant :
- des premier et deuxième transistors, connectés entre eux par un premier nœud de fourniture du niveau de sortie et électriquement en série entre des deuxièmes nœuds d'application des premiers niveaux ;
- un premier générateur de tension, alimenté par l'un des deuxièmes nœuds et configuré pour fournir une première tension continue définissant une limite haute de tension de commande du premier transistor ; et
- un deuxième générateur de tension commandé par une valeur représentative de la première tension, alimenté entre les deuxièmes nœuds et configuré pour fournir une deuxième tension continue définissant une limite haute de tension de commande du deuxième transistor.

Selon un mode de réalisation :
- un premier signal représentatif d'un état souhaité du deuxième transistor est référencé au potentiel dudit l'un des deuxièmes nœuds ; et
- de préférence, le premier signal est généré à partir d'un deuxième signal représentatif d'un état souhaité du premier transistor et référencé à un potentiel de référence des deuxièmes niveaux.

Selon l'invention :
- le premier générateur comprend un troisième transistor configuré pour être traversé par un premier courant d'alimentation du premier générateur ; et
- le deuxième générateur comprend un quatrième transistor formant un miroir de courant avec le troisième transistor et configuré pour être traversé par un deuxième courant d'alimentation du deuxième générateur.

Selon un mode de réalisation :
- le premier générateur comprend, électriquement en série avec le troisième transistor entre ledit l'un des deuxièmes nœuds et un troisième nœud de fourniture de la première tension, un premier élément présentant une chute prédéfinie de tension au passage du premier courant, le premier élément comprenant, de préférence, une diode ; et
- le deuxième générateur comprend un deuxième élément présentant une chute prédéfinie de tension lors du passage du deuxième courant, reliant un quatrième nœud à l'autre des deuxièmes nœuds, et comprenant, de préférence, un cinquième transistor et une diode électriquement en série.

Selon l'invention :
- un premier circuit de commande de transistor comprend :
- des premier, deuxième et troisième transistors supplémentaires électriquement en série dans cet ordre entre ledit l'un des deuxièmes nœuds et un nœud supplémentaire d'application de l'un des deuxièmes niveaux, le deuxième transistor supplémentaire ayant sa commande reliée à un nœud de fourniture de la première tension ;
- un nœud de connexion entre les premier et deuxième transistors supplémentaires, relié à une borne de commande de transistor commandée par le premier circuit ; et
- un deuxième circuit de commande de transistor comprend des quatrième, cinquième et sixièmes transistors supplémentaires électriquement en série dans cet ordre entre ledit l'un des deuxièmes nœuds et l'autre des deuxièmes nœuds, le cinquième transistor supplémentaire ayant sa commande reliée à un nœud de fourniture de la deuxième tension ; et un nœud de connexion entre les cinquième et sixième transistors supplémentaires relié à une borne de commande de transistor commandée par le deuxième circuit.

Selon un mode de réalisation, un circuit de commande du premier transistor est constitué du ou de l'un des premiers circuits et/ou un circuit de commande du deuxième transistor est constitué du ou de l'un des deuxièmes circuits.

Selon un mode de réalisation, le premier signal commande le quatrième transistor supplémentaire du circuit de commande du deuxième transistor.

Selon un mode de réalisation, le premier signal est généré par un autre des premiers circuits ayant son troisième transistor supplémentaire commandé par le deuxième signal.

Selon un mode de réalisation :
- le troisième transistor supplémentaire du circuit de commande du premier transistor est commandé par un signal inverse du deuxième signal ; et/ou
- le quatrième transistor supplémentaire du circuit de commande du deuxième transistor est commandé par un signal inverse du premier signal.

Selon un mode de réalisation :
- le signal inverse du premier signal est fourni par encore un autre des premiers circuits ayant son troisième transistor supplémentaire commandé par le signal inverse du deuxième signal et son premier transistor supplémentaire commandé par ledit un autre des premiers circuits ; et
- le premier transistor supplémentaire dudit un autre des premiers circuits est commandé par ledit encore un autre des premiers circuits.

Selon un mode de réalisation, le quatrième transistor supplémentaire d'un autre des deuxièmes circuits est commandé par le signal inverse du premier signal, et le sixième transistor du circuit de commande du deuxième interrupteur est commandé par ledit un autre des deuxièmes circuits.

Selon un mode de réalisation :
- encore un autre des deuxièmes circuits a son quatrième transistor supplémentaire commandé par le premier signal et a son sixième transistor supplémentaire commandé par ledit un autre des deuxièmes circuits ; et
- le sixième transistor supplémentaire dudit un autre des deuxièmes circuits est commandé par ledit encore un autre des deuxièmes circuits.

Selon un mode de réalisation, une valeur de la première tension continue est sélectionnée en fonction du niveau d'un signal logique d'activation/désactivation entre une valeur inférieure à un seuil de tension de commande du premier transistor et une valeur supérieure au seuil de tension.

Selon un mode de réalisation, le niveau de potentiel de sortie commande un écran d'affichage, de préférence de type OLED.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 représente, de manière schématique, un exemple de dispositif n'étant pas revendiqué auquel s'appliquent les modes de réalisation décrits ;
la figure 2 représente, de manière schématique, un exemple d'un mode de réalisation d'un translateur de niveau ;
la figure 3 représente, de manière schématique, un exemple d'un mode de réalisation d'un circuit du translateur de niveau de la figure 2 ;
la figure 4 représente, de manière partielle et schématique, un autre exemple d'un mode de réalisation d'un translateur de niveau ;
la figure 5 représente, de manière schématique, un exemple de circuit du translateur de la figure 4 ; et
la figure 6 représente, de manière schématique, un mode de réalisation d'un dispositif n'étant pas revendiqué comprenant des translateurs de niveau.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés. En particulier, des écrans d'affichage, des circuits de commande d'écran d'affichage, des unités numériques de génération de signaux de commande d'écran d'affichage, et des modules d'alimentation, ne sont pas décrits en détail, les modes de réalisation étant compatibles avec de tels éléments usuels.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 % près, de préférence à 5 % près.

Sauf précision contraire, les adjectifs numéraux ordinaux, tels que "premier", "deuxième", etc., sont utilisés seulement pour distinguer des éléments entre eux. En particulier, ces adjectifs ne limitent pas les dispositifs et procédés décrits à un ordre particulier de ces éléments.

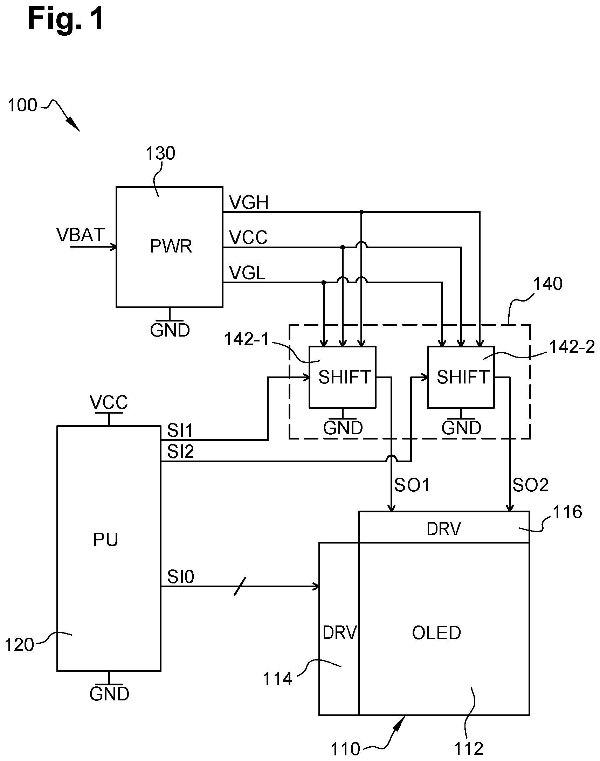

La figure 1 représente, de manière schématique, un exemple de dispositif 100 auquel s'appliquent les modes de réalisation décrits.

Dans cet exemple, le dispositif 100 est prévu pour afficher des images. Le dispositif 100 peut être utilisé dans un véhicule automobile pour afficher diverses informations, typiquement à destination du conducteur. Le véhicule automobile peut comprendre plusieurs dispositifs tels que le dispositif 100.

Le dispositif 100 comprend un écran d'affichage 110 pour afficher les images. L'écran d'affichage 110 comprend typiquement une matrice 112 (OLED) de pixels, telle qu'une matrice de diodes électroluminescentes organiques, OLED (de l'anglais "Organic Light-Emitting Diode"). La matrice 112 résulte, par exemple, d'un procédé d'impression. A titre d'exemple, la matrice 112 a une résolution connue sous le nom de "résolution 4K" ou supérieure, c'est-à-dire de 3840 ou plus par 2160 pixels ou plus.

L'écran d'affichage 110 comprend en outre des circuits de commande 114, 116 (DRV), typiquement configurés pour commander respectivement les lignes et les colonnes de la matrice 112. Dans l'exemple représenté, le circuit 116 commande un balayage des lignes de la matrice 112.

Le dispositif 100 comprend en outre une unité numérique 120 (PU), comprenant, par exemple, une unité de traitement séquentiel de données numériques, telle qu'un microprocesseur ou microcontrôleur, et, encore par exemple, une mémoire contenant un programme. L'unité numérique 120 est configurée, en particulier est programmée, pour fournir au circuit de commande 114 des signaux de commande SI0 à appliquer à l'écran d'affichage 110, et des signaux de commande SIi (SI1, SI2) à destination du circuit de commande 116. Le nombre de signaux SIi est égal à deux dans l'exemple représenté, et est typiquement, dans d'autres exemples, égal à quatre ou huit. Les signaux de commande SIi peuvent avoir une fréquence de l'ordre de 133 kHz.

Le dispositif 100 comprend en outre un module d'alimentation 130 (PWR). Le module d'alimentation 130 est alimenté par une tension VBAT, typiquement fournie par une batterie, non représentée. Le module d'alimentation 130 fournit, entre un nœud VCC et un nœud GND d'application d'un potentiel de référence, tel que la masse, une tension d'alimentation de l'unité numérique 120. Autrement dit, le module d'alimentation 130 applique des potentiels d'alimentation aux nœuds VCC et GND, l'unité numérique 120 étant reliée, de préférence connectée, aux nœuds VCC et GND.

Les signaux de commande SIi prennent chacun son niveau parmi les deux niveaux correspondant aux potentiels des nœuds respectifs VCC et GND. Autrement dit, les niveaux de potentiel pris par chaque signal de commande SIi sont, en dehors de fronts montants ou descendant du signal, égaux, ou sensiblement égaux, aux potentiels des nœuds VCC et GND. A titre d'exemple, la tension entre les nœuds VCC et GND est égale à 3,3 V ou à environ 3,3 V.

Le module d'alimentation 130 fournit en outre, sur des nœuds VGH et VGL, des potentiels d'alimentation de l'écran d'affichage 110. Les potentiels des nœuds VGH et VGL sont différents de ceux des nœuds respectifs VCC et GND. Typiquement, au moins le potentiel du nœud VGH est supérieur au potentiel du nœud VCC, par exemple le potentiel du nœud VGH est supérieur à 20 V (par rapport au potentiel de référence du nœud GND).

Le dispositif 100 comprend en outre une banque 140 de translateurs de niveau, ou bloc de translateurs de niveaux, recevant les signaux SIi. La banque 140 est reliée, de préférence connectée, au circuit de commande 116. Plus précisément, pour chacun des signaux SIi, la banque 140 comprend un translateur de niveau 142-i (142-1, 142-2, SHIFT) reliant le circuit de commande 116 à une sortie de l'unité numérique 120 sur laquelle l'unité numérique 120 fournit le signal SIi. Chaque translateur de niveau 142-i est relié, de préférence connecté, aux quatre nœuds GND, VCC, VGH et VGL.

Pour chacun des signaux SIi, le translateur de niveau 142-i fournit au circuit de commande 116 un niveau de potentiel de sortie parmi les deux niveaux correspondant au potentiel des nœuds VGH et VGL, en fonction du niveau du signal d'entrée SIi. Autrement dit, chaque translateur de niveau 142-i traduit le signal SIi concerné en un signal SOi (SO1, SO2) prenant ses niveaux parmi les niveaux des nœuds VGH et VGL. Les signaux SIi ont ainsi des niveaux compatibles avec l'application de ces signaux à l'écran d'affichage 110 par le circuit de commande 116.

Bien que l'on ai décrit ci-dessus un exemple particulier d'application de translateurs de niveaux, cet exemple n'est pas limitatif. Les modes de réalisation décrits sont compatibles avec toute application dans laquelle des signaux logiques sont transmis entre deux circuits utilisant des niveaux de potentiel respectifs différents.

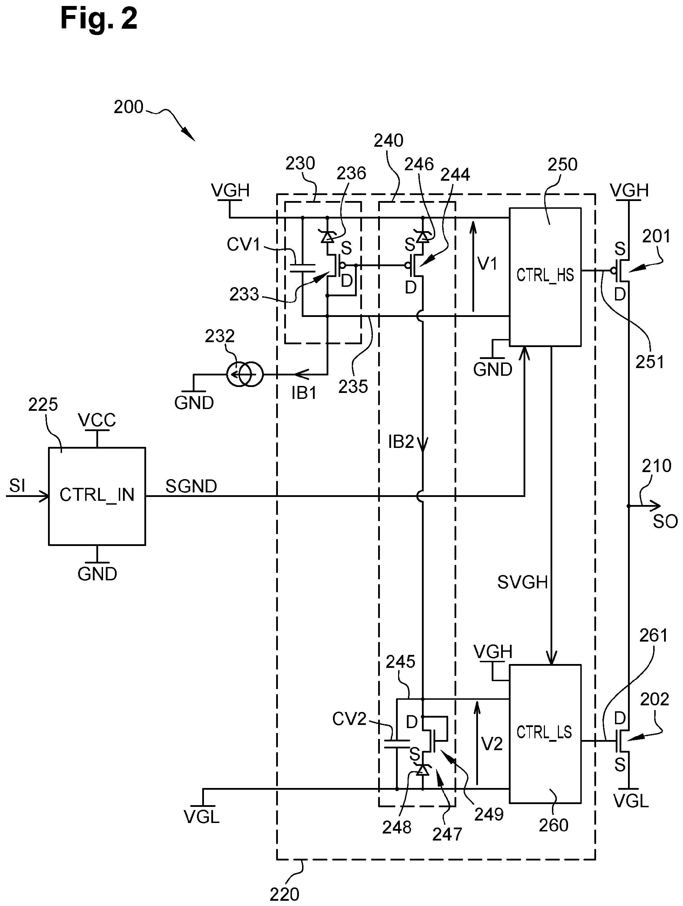

La figure 2 représente, de manière schématique, un exemple d'un mode de réalisation d'un translateur de niveau 200, c'est-à-dire un dispositif de décalage de niveau logique. Chacun des translateurs de niveau 142-i du dispositif 100 de la figure 1 peut être remplacé par le translateur de niveau 200. Le translateur de niveau 200 reçoit un signal d'entrée SI pouvant être l'un des signaux SIi du dispositif 100 de la figure 1, et fournit un signal de sortie SO pouvant être l'un des signaux SOi du dispositif 100 de la figure 1.

Le translateur de niveau 200 comprend deux transistors 201 et 202 électriquement en série entre les nœuds VGH et VGL. Le signal de sortie SO est fourni par le translateur de niveau 200 sur un nœud de connexion 210 entre les deux transistors 201 et 202.

De préférence, les transistors 201 et 202 sont des transistors à effet de champ à canaux respectifs de type P et N, le transistor 201 à canal P étant situé du côté du nœud VGH. En variante, d'autres types de transistors, ou des transistors à effet de champ ayant des canaux d'autres type de conductivité N, P, sont possibles.

Le translateur de niveau 200 comprend un circuit 220 commandant les grilles des transistors 201 et 202. Plus particulièrement, le circuit 220 est configuré pour appliquer, sur des sorties 251 et 261 du circuit 220, des commandes inverses aux transistors respectifs 201 et 202. Par commandes inverses, on entend que les commandes appliquées aux transistors 201 et 202 sont telles que, lorsque l'un des transistors 201 et 202 est passant, l'autre est bloqué. Les transistors 201 et 202 peuvent également être bloqués simultanément. Lorsque le transistor 201 est passant, le niveau de sortie du translateur de niveau 200 correspond au potentiel du nœud VGH. Lorsque le transistor 202 est passant, le niveau de sortie du translateur de niveau 200 correspond au potentiel du nœud VGL.

Le circuit 220 reçoit un signal logique SGND représentatif du niveau de sortie souhaité du translateur de niveau 200. Ainsi, le signal logique SGND est représentatif d'un état souhaité des transistors 201 et/ou 202. Le signal logique SGND est référencé au potentiel du nœud GND. Par signal logique référencé à un potentiel, on entend que les deux niveaux logiques de ce signal présentent chacun un écart constant avec ce potentiel, l'un des écarts pouvant être nul. En cas de variation de ce potentiel, les niveaux du signal logique présentent donc la même variation. Ce potentiel joue ainsi le rôle d'un potentiel de référence pour les niveaux du signal logique.

Le translateur de niveau 200 peut comprendre un circuit logique 225 (CTRL_IN) , alimenté entre les nœuds VCC et GND. Le circuit logique 225 reçoit un signal SI d'entrée du translateur de niveau 200. Le circuit logique 225 fournit le signal SGND à partir du signal SI. Le circuit logique 225 peut comprendre un inverseur ou un tampon ("buffer") recevant le signal SI et fournissant le signal SGND.

Dans l'exemple représenté, une partie 230 du circuit 220 comprend, électriquement en série entre le nœud VGH et un nœud 235, une diode 236 et un transistor 233, de préférence à effet de champ à canal P. La diode 236 peut comprendre une ou plusieurs diodes et/ou un ou plusieurs transistors à effet de champs montés en diode, électriquement en série et/ou en parallèle. Le transistor 233 est monté en diode, c'est-à-dire qu'il a des bornes de drain et de grille reliées entre elles, de préférence connectées entre elles. Le transistor 233 a une borne de source (S) tournée du côté du nœud VGH. La cathode de la diode 236 est tournée vers le nœud VGH. Le nœud 235 est relié, de préférence connecté, à une source de courant 232. Par exemple, la source de courant 232 relie le circuit 220 au nœud GND.

En fonctionnement, la source de courant prélève sur le nœud VGH un courant IB1 passant par la partie 230. La partie 230 fournit alors une tension continue V1 entre le nœud VGH et un nœud 235. Autrement dit, la partie 230 constitue un générateur de tension. A titre d'exemple, la tension continue V1 est comprise entre 4,8 et 4,9 V. A titre d'exemple, le courant IB1 a une valeur comprise entre 1 et 10 µA, par exemple égale à 2 µA ou environ 2 µA.

De préférence, on prévoit un élément capacitif CV1 entre les nœuds VGH et 235, c'est-à-dire en parallèle de l'association en série du transistor 233 et de la diode 236.

L'exemple représenté n'est pas limitatif. Dans une variante, on peut remplacer la diode 236 par tout élément présentant une chute prédéfinie de tension au passage d'un courant tel que le courant IB1. Un tel élément peut comprendre un ou plusieurs composants tels que des résistances, des transistors, des diodes ou des diodes Zener, etc., en série et/ou parallèle. Le générateur de tension 230 peut également être remplacé par tout générateur adapté à produire la tension V1 entre les nœuds VGH et 235 et alimenté par un courant fourni par le nœud VGH, tel que le courant IB1. De préférence, un tel générateur est alimenté entre les nœuds VGH et GND, c'est-à-dire que le courant fourni par le nœud VGH rejoint le nœud GND.

Le circuit 220 comprend un module 250 (CTRL_HS) de commande du transistor 201. Le module 250 est donc relié, de préférence connecté, à une borne de commande du transistor 201 (une borne de grille dans l'exemple d'un transistor à effet de champ). Le module 250 reçoit le signal SGND. Le module 250 est relié, de préférence connecté, au nœud GND. Le module 250 est également relié, de préférence connecté, aux nœuds VGH et 235.

En fonctionnement, le module 250 reçoit la tension V1 et fournit une tension de commande VGSP (non représentée) au transistor 201. De préférence, la tension de commande VGSP du transistor 201 prend deux valeurs de mise à l'état respectif passant et bloqué du transistor 201, en fonction de l'état souhaité de ce transistor.

Le module 250 est configuré pour que la tension de commande VGSP du transistor 201 soit toujours inférieure ou égale, en valeur absolue, à la tension V1. Autrement dit, la tension V1 constitue une limite haute de la tension de commande VGSP du transistor 201. En d'autres termes, la tension V1 constitue une limite haute de la valeur absolue |VGSP| de la tension de commande VGSP.

De préférence, le transistor 201 a une borne de source (S) située du côté du nœud VGH. La tension de commande VGSP du transistor 201 est alors appliquée entre les bornes de source et de grille du transistor 201. La valeur de mise à l'état bloqué prise par la tension de commande peut être proche de zéro, c'est-à-dire que le module 250 applique à la borne de grille du transistor 201 un potentiel sensiblement égal à celui du nœud VGH. La valeur de mise à l'état passant prise par la tension de commande peut être égale à la tension V1, ou à une valeur prédéfinie inférieure à la tension V1, par exemple présentant un écart constant avec la tension V1.

Il est souhaitable de limiter la tension de commande entre grille et source du transistor 201 afin de ne pas endommager ce transistor. Par exemple, l'application au transistor 201 d'une tension de commande proche de la tension entre les nœuds VGH et GND serait susceptible d'endommager ce transistor.

De préférence, une partie 240 du circuit 220 comprend, électriquement en série entre le nœud VGH et un nœud 245, une diode 246 et un transistor 244, de préférence à effet de champ à canal P. Le transistor 244 est préférentiellement monté en miroir de courant avec le transistor 233 et a une borne de source (S) située du côté du nœud VGH. La diode 246 a sa cathode tournée vers le nœud VGH.

De préférence, le transistor 244 a sa borne de commande reliée, de préférence connectée, aux bornes reliées entre elles de commande et de drain du transistor 233 du générateur de tension 230.

Plus préférentiellement :
- les diodes 236 et 246 sont, à des tolérances de fabrication près, identiques ;
- les diodes 236 et 246 sont situées entre le nœud VGH et les bornes de source (S) des transistors respectifs 233 et 244 ;
et
à des tolérances de fabrication près, les transistors 233 et 244 présentent entre eux un rapport de dimensions prédéfini, ou, plus préférentiellement, sont identiques.

En fonctionnement, le courant IB1 traverse le transistor 233. Le transistor 244 est traversé par un courant IB2 fourni par le nœud VGH. La valeur du courant IB2 présente avec celle du courant IB1 un rapport égal ou sensiblement égal au rapport de dimensions entre transistors 244 et 233. Autrement dit, les transistors 233 et 244 forment un miroir de courant. Les valeurs des courants IB1 et IB2 sont de préférence égales ou sensiblement égales.

L'exemple du miroir de courant représenté n'est pas limitatif. Le miroir de courant peut être tout miroir de courant adapté à fournir le courant IB2 à partir du courant IB1. Dans un autre exemple, les transistors 233 et 244 peuvent être directement connectés au nœud VGH. Dans encore un autre exemple, les diodes 236 et 246 sont remplacées par deux éléments respectifs adaptés à provoquer une même chute de tension aux passages des courants respectifs IB1 et IB2.

La partie 240 comprend en outre un ensemble 247 reliant les nœuds 245 et VGL. L'ensemble 247 comprend, électriquement en série entre les nœuds 245 et VGL, une diode 248 et un transistor 249 monté en diode. Le transistor 249 est, de préférence, à effet de champ à canal **N.** Le transistor 249 a alors sa source tournée vers le nœud VGL. La diode 248 a son anode tournée vers le nœud VGL.

En fonctionnement, le courant IB2 traverse l'ensemble 247. L'ensemble 247 provoque une chute prédéfinie de tension au passage du courant IB2. Cette chute de tension constitue une tension continue V2. Dans une variante, on peut remplacer l'ensemble 247 par tout élément présentant une chute prédéfinie de tension au passage d'un courant tel que le courant IB2.

La tension continue V2 est fournie entre les nœuds 245 et VGL à partir du courant IB2 circulant entre les nœuds VGH et VGL. Autrement dit, la partie 240 constitue un générateur de la tension V2 alimenté entre les nœuds VGH et VGL par le courant IB2. A titre d'exemple, la tension continue V2 est égale, ou sensiblement égale, à la tension V1.

De préférence, on prévoit un élément capacitif CV2 entre les nœuds VGL et 245, c'est-à-dire en parallèle de l'ensemble 247.

Dans l'exemple représenté, le générateur 240 de la tension V2 reçoit la tension V1 entre le nœud VGH et la borne de commande du transistor 244. Ainsi, la tension V1 commande le générateur de tension 240. Cet exemple n'est pas limitatif, le générateur de tension 240 peut être remplacé par tout générateur :
- adapté à produire la tension V2 entre les nœuds 245 et VGL ;
- alimenté entre les nœuds VGH et VGL ; et
- commandé par la tension V1 ou par toute valeur représentative de la tension V1, telle que, par exemple, une valeur du courant IB1.

Le circuit 220 comprend en outre un module 260 (CTRL_LS) de commande du transistor 202. Le module 260 est relié, de préférence connecté, aux nœud 245 et VGL. En fonctionnement, le module 260 reçoit la tension V2 et fournit une tension de commande VGSN (non représentée) au transistor 202. Le module 260 est configuré pour que la tension V2 constitue une limite haute de la tension de commande VGSN du transistor 202.

De préférence, le transistor 202 a une borne de source (S) située du côté du nœud VGL. La tension de commande VGSN du transistor 202 est alors appliquée entre les bornes de source et de grille du transistor 202. La valeur de mise à l'état bloqué prise par la tension de commande peut être proche de zéro, c'est-à-dire que le module 260 applique à la borne de grille du transistor 201 un potentiel sensiblement égal à celui du nœud VGL. La valeur de mise à l'état passant prise par la tension de commande peut être égale à la tension V2, ou à une valeur prédéfinie inférieure à la tension V2, par exemple ayant un écart constant avec la tension V2. On évite ainsi de risquer d'endommager le transistor 202.

On aurait pu penser prévoir, à la place du générateur 240, un autre générateur de la tension V2 alimenté entre les nœuds VGL et GND. Par exemple, dans les cas où le potentiel du nœud VGL est supérieur à celui du nœud GND, on aurait pu prévoir que cet autre générateur soit similaire au générateur de tension 230. Dans les cas où le potentiel du nœud VGL est inférieur à celui du nœud GND, on aurait pu prévoir que cet autre générateur diffère du générateur de tension 230 en ce que les types de conductivité N et P, en particulier les cathodes et anodes des diodes, sont échangés.

En comparaison, le fait de prévoir le générateur 240 alimenté entre les nœuds VGH et VGL et commandé par une tension représentative de la tension V1 permet de fournir la tension continue V2 de limitation de la tension de commande VGSN du transistor 202 avec un générateur 240 similaire lorsque le potentiel du nœud VGL est supérieur, sensiblement égal, ou inférieur à celui du nœud GND. En particulier, le même translateur de niveau 200 peut être utilisé pour des valeurs du potentiel du nœud VGL pouvant être positives ou négatives (par rapport au potentiel de référence du nœud GND). A titre d'exemple, le potentiel du nœud VGL peut prendre toute valeur comprise entre -10 V et 13 V. En outre ceci permet au potentiel du nœud VGL de pouvoir varier en cours de fonctionnement, et, en particulier, de pouvoir changer de signe, ce qui est souhaité dans certaines applications, en particulier d'affichage d'image.

Le module 260 reçoit un signal SVGH représentatif de l'état souhaité du transistor 202. Le signal SVGH est, de préférence, référencé par rapport au potentiel du nœud VGH. Le module 260 est alors relié, de préférence connecté, au nœud VGH. De préférence, le signal SVGH est fourni par le module 250, plus préférentiellement à partir du signal SGND. En variante, on peut prévoir que le circuit 220 fournisse le signal SVGH, de préférence référencé par rapport au potentiel du nœud VGH ou VGL.

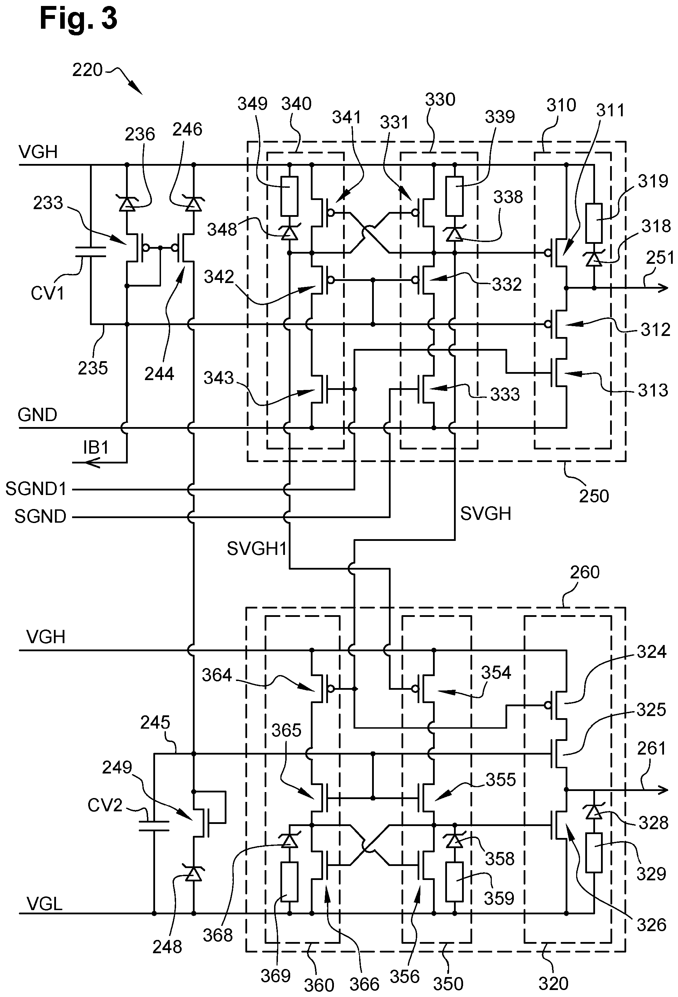

La figure 3 représente, de manière schématique, un exemple d'un mode de réalisation du circuit 220 du translateur de niveau 200 de la figure 2. Plus précisément, cet exemple comprend des éléments décrits ci-dessus en relation avec la figure 2. Ces éléments ne sont pas décrits à nouveau. Des exemples particuliers des modules 250 et 260 du circuit 220 sont détaillés. Les sorties 251 et 261 du circuit 220 sont reliées, de préférence connectées, aux bornes de commande des transistors respectifs 201 et 202 (figure 2).

Le module 250 comprend des circuits 310, 330, 340. Chaque circuit 310, 330, 340 comprend, électriquement en série dans cet ordre entre les nœuds VGH et GND :
- un premier transistor respectif 311, 331, 341 ;
- un deuxième transistor respectif 312, 332, 342 ;et
- un troisième transistor respectif 313, 333, 343.
Les deuxièmes transistors 312, 332 et 342 ont chacun une borne de commande reliée, de préférence connectée, au nœud 235 de fourniture de la tension continue V1.

De préférence, les premiers et deuxièmes transistors 311, 312, 331, 332, 341 et 342 sont à effet de champ à canal P et ont leurs bornes de sources situées du côté du nœud VGH. De préférence, les troisièmes transistors 313, 333 et 343 sont à effet de champ à canal N et ont leurs bornes de sources situées du côté du nœud GND.

Chacun des circuits 310, 330 et 340 génère un signal de commande de transistor, autrement dit, constitue un circuit de commande de transistor. Chacun des circuits 310, 330 et 340 a une sortie de commande de transistor constituée par un nœud de connexion entre les premier et deuxième transistors, respectivement, 311 et 312, 331 et 332, et 341 et 342.

Plus précisément, le circuit 310 commande le transistor 201 (figure 2), le circuit 330 commande les transistors 311 et 341, et le circuit 340 commande le transistor 331.

De préférence, chacun des circuits 310, 330 et 340 comprend, en série entre sa sortie de commande de transistor et le nœud VGH, une diode Zener, respectivement 318, 338 et 348, et un élément résistif tel qu'une résistance, respectivement 319, 339 et 349. Les diodes Zener 318, 338 et 348 ont leurs cathodes tournées vers le nœud VGH.

Dans chacun des circuits 310, 330 et 340, le premier transistor, respectivement 311, 331 et 341, et le troisième transistor, respectivement 313, 333 et 343, sont commandés en inverse. Les circuits 310, 330 et 340 sont alimentés entre les nœuds VGH et GND, autrement dit les courants de charge/décharge des grilles des transistors commandés par ces circuits sont fournis par les nœuds VGH et GND.

Lorsque le troisième transistor, respectivement 313, 333 et 343, est à l'état passant, le deuxième transistor, respectivement 312, 332 et 342 maintient le potentiel du nœud de connexion entre le premier transistor, respectivement 311, 331 et 341, et le deuxième transistor, respectivement 312, 332 et 342, à une valeur supérieure à celle du potentiel du nœud 235, par exemple égale à celle du potentiel du nœud 235 plus une tension de seuil de mise à l'état passant du deuxième transistor, respectivement 312, 332 et 342. Ainsi, la tension de commande de transistor fournie par chacun des circuits 310, 330 et 340 est limitée par la tension V1.

Dans chacun des circuits 310, 330 et 340, les diodes Zener 318, 338 et 348 servent à éviter que la commande fournie par ce circuit soit flottante lorsque le premier transistor, respectivement 311, 331 et 341, et le deuxième transistor, respectivement 312, 332 et 342, sont à l'état bloqué. Les valeurs des diodes Zener 318, 338 et 348 sont choisies pour que la tension de commande de transistor fournie par le circuit concerné 310, 330 ou 340 lorsque la diode Zener est passante soit suffisante pour rendre passant le transistor commandé concerné (c'est-à-dire supérieure à un seuil de tension de commande du transistor), et pour limiter, c'est-à-dire écrêter, cette tension de commande à des valeurs inférieures à un seuil de tension de commande admissible par le transistor commandé, sans détérioration. L'exemple représenté n'est pas limitatif, les diodes Zener 318, 338 et 348 et les résistances 319, 339 et 349 peuvent être omises ou remplacées par tout élément adapté à éviter que les sorties des circuits 310, 330 et 340 soient flottantes.

Le troisième transistor 333 du circuit 330 est commandé par le signal SGND. Le troisième transistor 313 du circuit 310 est commandé par un signal SGND1.

Le signal SGND1 est inverse du signal SGND et est référencé au potentiel du nœud GND. Le signal SGND1 peut être fourni par un inverseur, non représenté en figure 3, référencé au potentiel du nœud GND et recevant le signal SGND. Le troisième transistor 343 du circuit 340 est commandé par le signal SGND1.

Dans l'exemple représenté, les circuits 330 et 340 commandent un état du premier transistor 311 du circuit 310 de commande du transistor 201 (figure 2) inverse de l'état du troisième transistor 313 commandé par le signal SGND1. Cet exemple n'est pas limitatif, et les circuits 330 et 340 peuvent être remplacés par tout circuit configuré pour fournir au premier transistor 311 une commande à un état inverse de l'état du troisième transistor 313.

Dans l'exemple représenté, le circuit 340 commande le premier transistor 331 du circuit 330 à un état inverse de celui commandé au troisième transistor 333 du circuit 330 par le signal SGND. Cet exemple n'est pas limitatif, et le circuit 340 peut être remplacé par tout circuit configuré pour commander le premier transistor 331 du circuit 330 à un état inverse de celui du troisième transistor 333.

Dans l'exemple représenté, le circuit 330 commande le premier transistor 341 du circuit 340 à un état inverse de l'état commandé au troisième transistor 343 du circuit 340 par le signal SGND1. Un avantage est que les premiers transistors 331 et 341 des circuits 330 et 340 forment un verrou (en anglais "latch") permettant de stabiliser l'état de la commande fournie au transistor 201.

De préférence, le signal SVGH fourni par le module 250 est le signal de commande de transistor fourni par le circuit 330, ou est obtenu à partir de ce signal de commande de transistor.

Dans l'exemple représenté, le module 250 fournit en outre un signal SVGH1 inverse du signal SVGH. Le signal SVGH1 est référencé au potentiel du nœud VGH. De préférence, le signal SVGH1 fourni par le module 250 est le signal de commande de transistor fourni par le circuit 340, ou est obtenu à partir de ce signal de commande de transistor.

On a décrit ci-dessus un exemple particulier du module 250 de commande du transistor 201 (figure 2). Cet exemple n'est pas limitatif, le module 250 pouvant être constitué par tout circuit adapté à commander le transistor 201 à l'état souhaité représenté par le signal SGND et à limiter la tension de commande VGSP du transistor 201 à une valeur inférieure à la tension V1 (figure 2). De préférence, le module 250 est alimenté entre les nœuds VGH et GND.

Le module 260 comprend des circuits 320, 350, 360. Chaque circuit 320, 350, 360 comprend, électriquement en série dans cet ordre entre les nœuds VGH et VGL :
- un quatrième transistor respectif 324, 354, 364 ;
- un cinquième transistor respectif 325, 355, 365 ; et
- un sixième transistor respectif 326, 356, 366.
Les cinquièmes transistors 325, 355, 365 ont chacun leur borne de commande reliée, de préférence connectée, au nœud 245 de fourniture de la tension continue V2.

De préférence, les cinquièmes et sixièmes transistors 325, 326, 355, 356, 365 et 366 sont à effet de champ à canal N et ont leurs bornes de source situées du côté du nœud VGL. De préférence, les quatrièmes transistors 324, 354 et 364 sont à effet de champ à canal P et ont leurs bornes de source situées du côté du nœud VGH.

Chacun des circuits 320, 350 et 360 génère un signal de commande de transistor. Chacun des circuits 320, 350 et 360 a une sortie de commande de transistor constituée par un nœud de connexion entre les cinquième et sixième transistors, respectivement, 325 et 326, 355 et 356, et 365 et 366.

Plus précisément, le circuit 320 commande le transistor 202 (figure 2), le circuit 350 commande les transistors 326 et 366, et le circuit 360 commande le transistor 356.

De préférence, chacun des circuits 320, 350 et 360 comprend, en série entre sa sortie de commande de transistor et le nœud VGL, une diode Zener, respectivement 328, 358 et 368, et un élément résistif, respectivement 329, 359 et 369. Les diodes Zener 328, 358 et 368 ont leurs anodes tournées vers le nœud VGL.

Dans chacun des circuits 320, 350 et 360, le quatrième transistor, respectivement 324, 354 et 364, et le sixième transistor, respectivement 326, 356 et 366, sont commandés en inverse. Les circuits 320, 350 et 360 sont alimentés entre les nœuds VGH et VGL.

Lorsque le quatrième transistor, respectivement 324, 354 et 364, est à l'état passant, le cinquième transistor, respectivement 325, 355 et 365 maintient le potentiel du nœud de connexion entre le cinquième transistor, respectivement 325, 355 et 365, et le sixième transistor, respectivement 326, 356 et 366, à une valeur inférieure à celle du potentiel du nœud 245, par exemple égale à celle du potentiel du nœud 245 moins une tension de seuil de mise à l'état passant du cinquième transistor, respectivement 325, 355 et 365. Ainsi, la tension de commande de transistor fournie par chacun des circuits 320, 350 et 360 est limitée par la tension V2.

Dans chacun des circuits 320, 350 et 360, les diodes Zener 328, 358 et 368 servent à éviter que la commande fournie par ce circuit soit flottante lorsque le cinquième transistor, respectivement 325, 355 et 365, et le sixième transistor, respectivement 326, 356 et 366, sont à l'état bloqué. Les valeurs des diodes Zener 328, 358 et 368 sont choisies pour que la tension de commande de transistor fournie par le circuit 320, 350 ou 360 lorsque la diode Zener est passante soit suffisante pour rendre passant le transistor commandé concerné et pour limiter, c'est-à-dire écrêter, cette tension de commande à des valeurs inférieures à un seuil de tension de commande admissible par le transistor commandé, sans détérioration.

L'exemple représenté n'est pas limitatif, les diodes Zener 328, 358 et 368 et les éléments résistifs 329, 359 et 369 peuvent être omis ou remplacés par tout élément adapté à éviter que les sorties des circuits 320, 350 et 360 soient flottantes.

Le quatrième transistor 354 du circuit 350 est commandé par le signal SVGH1. Le quatrième transistor 324 du circuit 320 est commandé par un signal SVGH. Le quatrième transistor 364 du circuit 360 est commandé par le signal SVGH.

Dans l'exemple représenté, les circuits 350 et 360 commandent un état du sixième transistor 326 du circuit 320 de commande du transistor 202 (figure 2) inverse de celui du quatrième transistor 324 commandé par le signal SVGH. Cet exemple n'est pas limitatif, et les circuits 350 et 360 peuvent être remplacés par tout circuit configuré pour fournir au sixième transistor 326 une commande à un état inverse de l'état celui du quatrième transistor 324.

Dans l'exemple représenté, le circuit 360 commande le sixième transistor 356 du circuit 350 à un état inverse de celui commandé au quatrième transistor 354 du circuit 350 par le signal SVGH1. Cet exemple n'est pas limitatif, et le circuit 360 peut être remplacé par tout circuit configuré pour commander le sixième transistor 356 du circuit 350 à un état inverse de celui du quatrième transistor 354.

Dans l'exemple représenté, le circuit 350 commande le sixième transistor 366 du circuit 360 à un état inverse de celui commandé au quatrième transistor 364 du circuit 360 par le signal SVGH. Un avantage est que les sixièmes transistors 356 et 366 des circuits 350 et 360 forment un verrou.

Bien que, dans l'exemple représenté, le signal SVGH1 soit fourni par le module 250, le signal SVGH1 peut être généré dans le module 260 par tout circuit adapté, par exemple alimenté entre les nœuds VGH et VGL d'alimentation du module 260.

On a décrit ci-dessus un exemple particulier de module 260 de commande du transistor 202 (figure 2). Cet exemple n'est pas limitatif, le module 260 pouvant être constitué par tout circuit adapté à commander le transistor 202 à l'état souhaité représenté par le signal SVGH et à limiter la tension de commande VGSN du transistor 202 à une valeur inférieure à la tension V2 (figure 2). De préférence, le module 260 est alimenté entre les nœuds VGH et VGL.

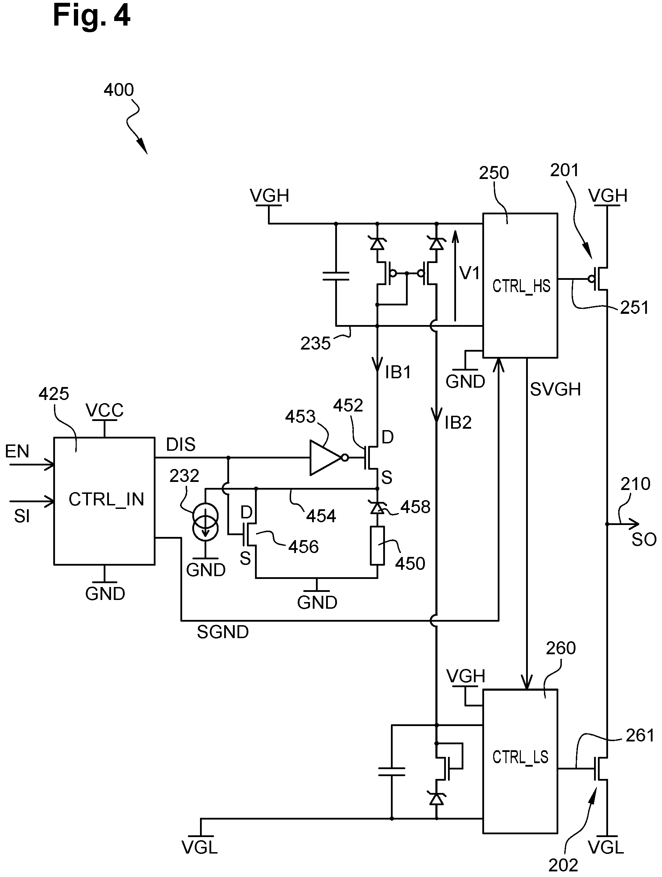

La figure 4 représente, de manière partielle et schématique, un autre exemple d'un mode de réalisation d'un translateur de niveau 400. Le translateur de niveau 400 peut être utilisé à la place de l'un des translateurs de niveau 142-i du dispositif 100 de la figure 1. Le translateur de niveau 400 comprend des mêmes éléments que le translateur de niveau 200 de la figure 2, et, en particulier, peut comprendre les modules 250 et 260 décrits en relation avec la figure 3. Ces éléments ne sont pas décrits à nouveau, seules les différences sont mises en exergue.

Le translateur de niveau 400 diffère du translateur de niveau 200 de la figure 2 en ce que le circuit logique 225 est remplacé par un circuit logique 425. Le circuit logique 425 diffère du circuit logique 225 du translateur de niveau 200 de la figure 2 en ce que, outre la fourniture du signal SGND à partir du signal SI, le circuit logique 425 fournit un signal de désactivation DIS. Le signal de désactivation peut être obtenu à partir d'un signal d'activation EN. Dans le cas où le translateur de niveau 400 remplace l'un des translateurs 142-i du dispositif 100 de la figure 1, le signal d'activation EN peut être fourni par l'unité numérique 120 (figure 1).

Dans le translateur de niveau 400, le nœud 235 n'est pas connecté directement à la source de courant 232, mais est relié à la source de courant par un transistor 452, de préférence à effet de champ à canal N. Le transistor 452 une borne de drain (D) tournée vers le nœud 235. Le transistor 452 est commandé par un inverseur 453 recevant le signal de désactivation DIS.

De préférence, une borne de source (S) du transistor 452 constitue un nœud de connexion 454 entre le transistor 452 et la source de courant 232. Les nœuds 454 et GND sont reliés entre eux par un transistor 456, de préférence à effet de champ à canal N, dont une borne de source (S) est du côté du nœud GND. Le transistor 456 est commandé par le signal de désactivation DIS.

De préférence, le translateur de niveau 400 comprend en outre une diode 458 et un élément résistif 459, électriquement en série entre les nœuds 454 et GND, autrement dit en parallèle du transistor 456.

En fonctionnement, lorsque le signal de désactivation DIS est à un niveau bas, le transistor 452 est passant. Le courant IB1 circule, ce qui permet d'obtenir pour les tensions continues V1 et V2 des valeurs suffisantes pour que l'état passant/bloqué des transistors 201 et 202 soit commandé par les modules 250 et 260 en fonction de l'état souhaité représenté par le signal SI. Les tensions continues V1 et V2 ont alors des valeurs supérieures aux seuils de tension de commande de mise à l'état passant des interrupteurs respectifs 201 et 202.

Lorsque le signal de désactivation est à un niveau haut, le transistor 452 est bloqué, et les tensions V1 et V2 sont nulles. Il en résulte que les tensions de commande des transistors 201 et 202 sont limitées à la valeur nulle, autrement dit, les transistors 201 et 202 sont bloqués simultanément et la sortie du translateur de niveau 400 est à un état de potentiel flottant. Un tel état de potentiel flottant est dit état de haute impédance.

Dans un procédé d'affichage d'images tel que mis en œuvre par un dispositif du type de celui de la figure 1 dans lequel les translateurs de niveau 142-i sont remplacés par le translateur de niveau 400, on peut avantageusement prévoir des étapes auxquelles la commande de l'écran d'affichage 110 (figure 1) est ainsi désactivée.

L'exemple représenté n'est pas limitatif, le translateur de niveau 400 pouvant comprendre, à la place des transistors 452 et 456, de l'inverseur 453, de la diode 458 et de l'élément résistif 459, tout circuit configuré pour mettre les tensions continues V1 et V2 à des valeurs inférieures aux seuils de tension de commande à l'état passant des transistors respectifs 201 et 202. En particulier, ce circuit permet de sélectionner la valeur de la tension V1 en fonction du niveau du signal DIS ou du signal EN entre deux valeurs inférieure et supérieure au seuil de tension de commande VGSP du transistor 201.

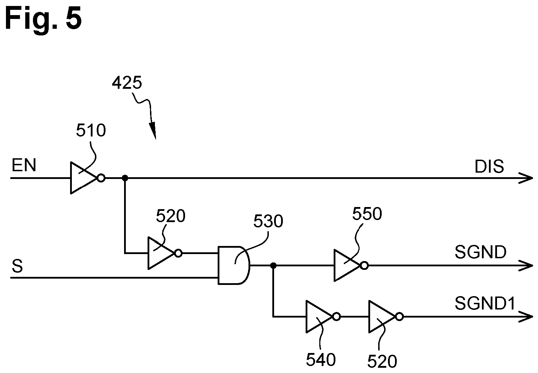

La figure 5 représente, de manière schématique, un exemple du circuit logique 425 du translateur de niveau 400 de la figure 4. Plus précisément, le circuit logique 425 représenté correspond à l'exemple dans lequel le signal SGND1 (figure 3) est fourni au module 250. Le circuit logique 425 fournit ce signal SGND1 en plus des signaux SGND et DIS représentés en figure 4. De plus, Le circuit logique 425 comprend des éléments actifs tels que des inverseurs et des portes logiques. Ces éléments sont alimentés entre les nœuds VCC et GND, ces nœuds n'étant pas représentés en figure 5.

Le circuit logique 425 comprend :
- un inverseur 510 recevant le signal EN et fournissant le signal DIS ;
- un inverseur 520 recevant le signal DIS ;
- une porte logique ET 530 ayant une entrée reliée, de préférence connectée, à la sortie de l'inverseur 520 ;
- un inverseur 550 ayant son entrée reliée, de préférence connectée, à la sortie de la porte logique ET 530, et fournissant le signal SGND ; et
- des inverseurs 540 et 542 en série, c'est-à-dire formant un circuit tampon. L'entrée de l'inverseur 540 est reliée, de préférence connectée, à la sortie de la porte logique ET 530, et la sortie de l'inverseur 542 fournit le signal SGND1.

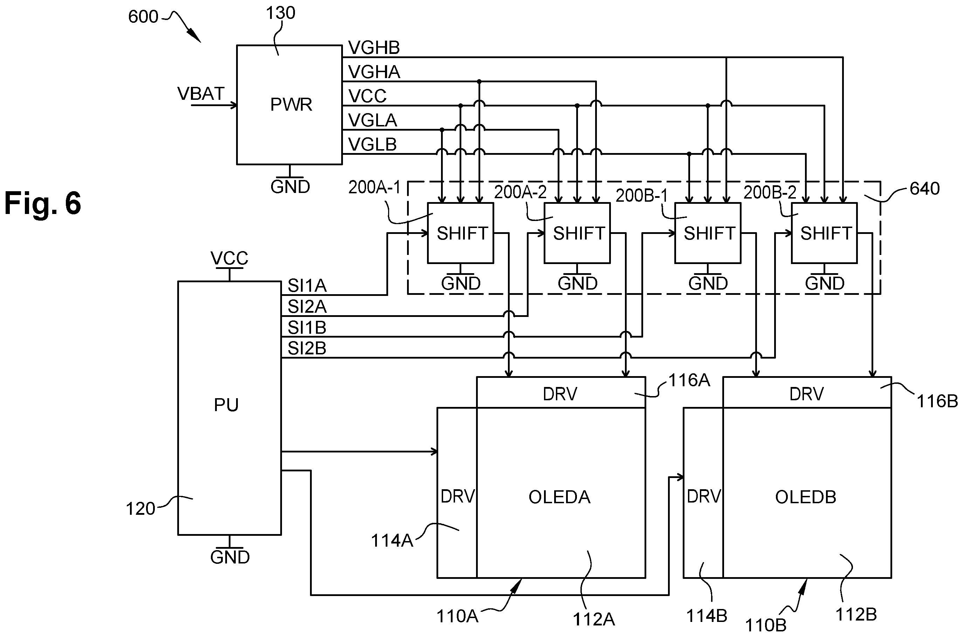

La figure 6 représente, de manière schématique, un mode de réalisation d'un dispositif 600 comprenant des translateurs de niveau.

Le dispositif 600 comprend des éléments identiques ou similaires à ceux du dispositif 100 de la figure 1. Ces éléments ne sont par décrits à nouveau en détail. Seules les différences sont mises en exergue.

Le dispositif 600 diffère du dispositif 100 de la figure 1 en ce que :
- le dispositif 600 comprend, à la place de l'écran d'affichage 110, deux écrans d'affichage 110A (OLEDA) et 110B (OLEDB) comprenant chacun une matrice de pixels respectives 112A et 112B, un circuit de commande respectif 114A et 114B et un autre circuit de commande respectif 116A et 116B ;
- le module d'alimentation 130 fournit, à la place du potentiel du nœud VGH, des potentiels différents sur deux nœuds VGHA et VGHB, et, à la place du potentiel du nœud VGL, des potentiels différents sur deux nœuds VGLA et VGLB ;
- l'unité numérique 120 fournit, à la place des signaux SIi, des signaux SIiA (SI1A et SI2A) à destination du circuit de commande 116A, et des signaux SIiB (SI1B et SI2B) à destination du circuit de commande 116B ; et
- l'unité numérique 120 est reliée, de préférence connectée, aux circuits de commande 114A et 114B.

Les écrans d'affichage 110A et 110B peuvent être du type de l'écran d'affichage 110 (figure 1), les matrices 112A et 112B correspondant à la matrice 112, les circuits de commande 114A et 114B correspondant au circuit de commande 114 (figure 1), et les autres circuits de commande 116A et 116B correspondant au circuit de commande 116 (figure 1). De préférence, les écrans d'affichage 110A et 110B diffèrent l'un de l'autre en ce que l'écran d'affichage 110A est alimenté entre les nœuds VGHA et VGLA qui ont des potentiels différents de ceux des nœuds VGHB et VGLB d'application des potentiels d'alimentation de l'écran d'affichage 110B. Par exemple, l'un des potentiels des nœuds VGLA, VGLB est positif, et l'autre des potentiels des nœuds VGLA, VGLB est négatif.

Selon le présent mode de réalisation, on prévoit un ensemble 640 comprenant plusieurs translateurs de niveau tous identiques (à des tolérances de fabrication près). Dans l'exemple représenté, l'ensemble 640 comprend quatre translateurs de niveau 200A-1, 200A-2, 200B-1, 200B-2. Les translateurs de niveau sont similaires ou identiques au translateur de niveau 200 de la figure 2. Les translateurs de niveau 200A-1, 200A-2, 200B-1, 200B-2 (SHIFT) peuvent également être tous similaires ou identiques au translateur de niveau 400 de la figure 4, des liaisons supplémentaires, non représentées, étant alors prévues entre l'unité numérique 120 et les translateurs de niveau 400 pour véhiculer des signaux d'activation/désactivation.

De préférence, l'ensemble 640 est un circuit intégré monolithique, c'est-à-dire situé dans et sur une même portion de plaquette (en anglais "wafer") semiconductrice. De préférence, l'ensemble 640 est situé dans un boîtier de circuit intégré. Par boîtier de circuit intégré, on entend que ce boîtier, de préférence étanche, présente des plages de connexion ou des broches de connexion du circuit intégré à d'autres circuits électroniques extérieurs au boîtier, par exemple à un circuit imprimé, PCB (en anglais "Printed Circuit Board").

Les translateurs de niveau 200A-1 et 200A-2 sont reliés, de préférence connectés, aux nœuds VCC, VGHA et VGLA. Les translateurs de niveau 200A-1 et 200A-2 forment une banque de translateurs de niveau fournissant des signaux de commande au circuit de commande 116A. Les translateurs de niveau 200B-1 et 200B-2 sont reliés, de préférence connectés, aux nœuds VCC, VGHB et VGLB. Les translateurs de niveau 200B-1 et 200B-2 forment une banque de translateurs de niveau fournissant des signaux de commande au circuit de commande 116B.

Bien que l'on ait représenté un exemple dans lequel l'ensemble 640 comprend 4 translateurs de niveau identiques constituant deux banques associées respectivement à deux écrans d'affichage, on peut prévoir un nombre d'écrans d'affichage supérieur à deux. On peut en outre prévoir plus de deux translateurs de niveau par banque, c'est-à-dire par écran d'affichage, par exemple quatre ou huit translateurs de niveau par écran d'affichage.

Un avantage du dispositif 600 est qu'il permet, à partir du même ensemble 640, de connecter divers écrans d'affichage alimentés entre des potentiels haut et bas différents, les potentiels bas pouvant être, pour un même ensemble, de signes différents pour deux écrans d'affichage différents.

Divers modes de réalisation et variantes ont été décrits. En particulier, bien que l'on ait décrit des modes de réalisation dans lesquels le nœud VGH a un potentiel supérieur à celui du nœud VGL et à celui du nœud GND, d'autres modes de réalisation peuvent être obtenus en inversant les signes des potentiels (référencés par rapport au potentiel du nœud GND), en permutant les types de conductivité N et P des canaux des transistors et en permutant les anodes et cathodes des diodes, les sens de circulation des courants en fonctionnement étant en outre inversés.

Enfin, la mise en œuvre pratique des modes de réalisation et variantes décrits est à la portée de la personne du métier à partir des indications fonctionnelles données ci-dessus. En particulier, le choix de chaque transistor, plus particulièrement la tension drain-source maximale que le transistor est capable de bloquer, peut être fait d'une manière usuelle à partir des niveaux de tension/courant que le transistor est amené à bloquer dans les fonctionnements décrits ci-dessus.

## Revendications

1. Procédé de fourniture d'un niveau de potentiel de sortie parmi deux premiers niveaux en fonction d'un niveau d'entrée parmi deux deuxièmes niveaux, pour le décalage de niveau logique, comprenant :
- la fourniture du niveau de sortie par un premier nœud (210) connectant entre eux des premier (201) et deuxième (202) transistors électriquement en série entre deux deuxièmes nœuds (VGH, VGL) d'application des premiers niveaux ;
- la fourniture, par un premier générateur de tension (230) alimenté par l'un des deuxièmes nœuds (VGH), d'une première tension continue (V1) définissant une limite haute de tension de commande du premier transistor ; et
- la fourniture, par un deuxième générateur (240) de tension commandé par une valeur représentative de la première tension et alimenté entre les deuxièmes nœuds, d'une deuxième tension continue (V2) définissant une limite haute de tension de commande du deuxième transistor, dans lequel :
- le premier générateur (230) comprend un troisième transistor (233) configuré pour être traversé par un premier courant (IB1) d'alimentation du premier générateur ; et
- le deuxième générateur (240) comprend un quatrième transistor (244) formant un miroir de courant avec le troisième transistor et configuré pour être traversé par un deuxième courant (IB2) d'alimentation du deuxième générateur ;
- un premier circuit de commande (310) de transistors comprend :
- des premier, deuxième et troisième transistors supplémentaires (311, 312, 313) électriquement en série dans cet ordre entre ledit l'un des deuxièmes nœuds (VGH) et un nœud supplémentaire (GND) d'application de l'un des deuxièmes niveaux, le deuxième transistor supplémentaire ayant sa commande reliée à un nœud (235) de fourniture de la première tension (V1) ;
- un nœud de connexion entre les premier et deuxième transistors supplémentaires, relié à une borne de commande du premier transistor commandée par le premier circuit, le premier transistor supplémentaire étant commandé à un état inverse de l'état du troisième transistor supplémentaire ; et
- un deuxième circuit de commande (320) de transistors comprend :
- des quatrième, cinquième et sixième transistors supplémentaires (324, 325, 326) électriquement en série dans cet ordre entre ledit l'un des deuxièmes nœuds (VGH) et l'autre des deuxièmes nœuds (VGL), le cinquième transistor supplémentaire ayant sa commande reliée à un nœud (245) de fourniture de la deuxième tension (V2) ;
- un nœud de connexion entre les cinquième et sixième transistors supplémentaires relié à une borne de commande du deuxième transistor commandée par le deuxième circuit, le quatrième transistor supplémentaire étant commandé à un état inverse de l'état du sixième transistor supplémentaire.

2. Dispositif (200, 400) de décalage de niveau logique configuré pour fournir un niveau de potentiel de sortie parmi deux premiers niveaux en fonction d'un niveau d'entrée parmi deux deuxièmes niveaux, comprenant :
- des premier (201) et deuxième (202) transistors, connectés entre eux par un premier nœud (210) de fourniture du niveau de sortie et électriquement en série entre des deuxièmes nœuds (VGH, VGL) d'application des premiers niveaux ;
- un premier générateur de tension (230), alimenté par l'un des deuxièmes nœuds (VGH) et configuré pour fournir une première tension continue (V1) définissant une limite haute de tension de commande du premier transistor ; et
- un deuxième générateur de tension (240) commandé par une valeur représentative de la première tension, alimenté entre les deuxièmes nœuds et configuré pour fournir une deuxième tension continue (V2) définissant une limite haute de tension de commande du deuxième transistor,
dans lequel :
- le premier générateur (230) comprend un troisième transistor (233) configuré pour être traversé par un premier courant (IB1) d'alimentation du premier générateur ; **caractérisé en ce que**:
- le deuxième générateur (240) comprend un quatrième transistor (244) formant un miroir de courant avec le troisième transistor et configuré pour être traversé par un deuxième courant (IB2) d'alimentation du deuxième générateur,
le dispositif comprenant en outre :
- un premier circuit de commande (310) de transistors
comprenant :
- des premier, deuxième et troisième transistors supplémentaires (311, 312, 313) électriquement en série dans cet ordre entre ledit l'un des deuxièmes nœuds et un nœud supplémentaire d'application de l'un des deuxièmes niveaux, le deuxième transistor supplémentaire ayant sa commande reliée à un nœud de fourniture de la première tension (V1) ;
- un nœud de connexion entre les premier et deuxième transistors supplémentaires, relié à une borne de commande du premier transistor commandée par le premier circuit, le premier transistor supplémentaire étant commandé à un état inverse de l'état du troisième transistor supplémentaire ; et
un deuxième circuit de commande (320) de transistors comprenant :
des quatrième, cinquième et sixième transistors supplémentaires (324, 325, 326) électriquement en série dans cet ordre entre ledit l'un des deuxièmes nœuds et l'autre des deuxièmes nœuds, le cinquième transistor supplémentaire ayant sa commande reliée à un nœud de fourniture de la deuxième tension (V2) ;
un nœud de connexion entre les cinquième et sixième transistors supplémentaires relié à une borne de commande du deuxième transistor commandée par le deuxième circuit, le quatrième transistor supplémentaire étant commandé à un état inverse de l'état du sixième transistor supplémentaire.

3. Procédé selon la revendication 1 ou dispositif selon la revendication 2, dans lequel :
- un premier signal (SVGH ; SVGH1) représentatif d'un état souhaité du deuxième transistor (202) est référencé au potentiel dudit l'un des deuxièmes nœuds (VGH) ; et
- de préférence, le premier signal (SVGH ; SVGH1) est généré à partir d'un deuxième signal (SGND ; SGND1) représentatif d'un état souhaité du premier transistor (201) et référencé à un potentiel de référence des deuxièmes niveaux.

4. Procédé selon la revendication 1 ou 3, ou dispositif selon la revendication 2 ou 3, dans lequel :
- le premier générateur (230) comprend, électriquement en série avec le troisième transistor (233) entre ledit l'un des deuxièmes nœuds (VGH) et un troisième nœud (235) de fourniture de la première tension (V1), un premier élément (236) présentant une chute prédéfinie de tension au passage du premier courant (IB1), le premier élément comprenant, de préférence, une diode ; et
- le deuxième générateur (240) comprend un deuxième élément (247) présentant une chute prédéfinie de tension lors du passage du deuxième courant (IB2), reliant un quatrième nœud à l'autre des deuxièmes nœuds (VGL), et comprenant, de préférence, un cinquième transistor (249) et une diode (248) électriquement en série.

5. Procédé selon l'une quelconque des revendications 1, 3 ou 4, ou dispositif selon l'une quelconque des revendications 2 à 4, dans lequel un circuit de commande (310) du premier transistor (201) est constitué du ou de l'un des premiers circuits (310) et/ou un circuit de commande (320) du deuxième transistor (202) est constitué du ou de l'un des deuxièmes circuits (320).

6. Procédé ou dispositif selon la revendication 5 dans sa dépendance à la revendication 3, dans lequel le premier signal (SVGH) commande le quatrième transistor supplémentaire (324) du circuit de commande (320) du deuxième transistor (202).

7. Procédé ou dispositif selon la revendication 5 dans sa dépendance à la revendication 3 ou selon la revendication 6, dans lequel le premier signal (SVGH) est généré par un autre des premiers circuits (330) ayant son troisième transistor supplémentaire (333) commandé par le deuxième signal (SGND).

8. Procédé ou dispositif selon l'une quelconque des revendications 5 à 7 dans sa dépendance à la revendication 3, dans lequel :
- le troisième transistor supplémentaire (313) du circuit de commande (310) du premier transistor (201) est commandé par un signal (SGND1) inverse du deuxième signal (SGND) ; et/ou
- le quatrième transistor supplémentaire (324) du circuit de commande (320) du deuxième transistor (202) est commandé par un signal (SVGH) inverse du premier signal (SVGH1).

9. Procédé ou dispositif selon la revendication 8, dans lequel :
- le signal inverse (SVGH) du premier signal (SVGH1) est fourni par encore un autre des premiers circuits (330) ayant son troisième transistor supplémentaire (333) commandé par le signal (SGND) inverse du deuxième signal (SGND1) et son premier transistor supplémentaire (331) commandé par ledit un autre des premiers circuits (340) ; et
- le premier transistor supplémentaire (341) dudit un autre des premiers circuits (340) est commandé par ledit encore un autre des premiers circuits.

10. Procédé ou dispositif selon la revendication 8 ou 9, dans lequel le quatrième transistor supplémentaire (354) d'un autre des deuxièmes circuits (350) est commandé par le signal (SVGH1) inverse du premier signal (SVGH), et le sixième transistor (326) du circuit de commande du deuxième interrupteur (320) est commandé par ledit un autre des deuxièmes circuits.

11. Procédé ou dispositif selon la revendication 10, dans lequel :
- encore un autre des deuxièmes circuits (360) a son quatrième transistor supplémentaire (364) commandé par le premier signal (SVGH) et a son sixième transistor supplémentaire (366) commandé par ledit un autre des deuxièmes circuits (350) ; et
- le sixième transistor supplémentaire dudit un autre des deuxièmes circuits étant commandé par ledit encore un autre des deuxièmes circuits.

12. Procédé selon l'une quelconque des revendications 1 et 3 à 11, ou dispositif selon l'une quelconque des revendications 2 à 11, dans lequel une valeur de la première tension continue (V1) est sélectionnée en fonction du niveau d'un signal logique d'activation/désactivation (EN ; DIS) entre une valeur inférieure à un seuil de tension de commande du premier transistor (201) et une valeur supérieure au seuil de tension.

13. Procédé selon l'une quelconque des revendications 1 et 3 à 12, ou dispositif selon l'une quelconque des revendications 2 à 12, dans lequel le niveau de potentiel de sortie commande un écran d'affichage, de préférence de type OLED.

## Patentansprüche

1. Ein Verfahren zum Bereitstellen eines Ausgangspotentialpegels aus zwei ersten Pegeln entsprechend einem Eingangspegel aus zwei zweiten Pegeln, wobei das Verfahren Folgendes aufweist:
- das Bereitstellen des Ausgangspegels durch einen ersten Knoten (210), der einen ersten (201) und einen zweiten (202) Transistor elektrisch in Reihe zwischen zwei zweiten Knoten (VGH, VGL) zum Anlegen der ersten Pegel verbindet;
- das Bereitstellen, durch einen ersten Spannungsgenerator (230), der von einem der zweiten Knoten (VGH) gespeist wird, einer ersten Gleichspannung (V1), die eine Obergrenze für die Steuerspannung des ersten Transistors definiert; und
- das Bereitstellen, durch einen zweiten Spannungsgenerator (240), der durch einen Wert gesteuert wird, der für die erste Spannung repräsentativ ist, und der zwischen den zweiten Knoten versorgt wird, einer zweiten Gleichspannung (V2), die eine Obergrenze für die Steuerspannung des zweiten Transistors definiert,
wobei:
- der erste Generator (230) einen dritten Transistor (233) aufweist, der konfiguriert ist zum Leiten eines ersten Stroms (IB1) zum Versorgen des ersten Generators; und
- der zweite Generator (240) einen vierten Transistor (244) aufweist, der mit dem dritten Transistor einen Stromspiegel ausbildet und konfiguriert ist zum Leiten eines zweiten Stroms (IB2) zum Versorgen des zweiten Generators;
- eine erste Transistorsteuerschaltung Folgendes aufweist:
- einen ersten, einen zweiten und einen dritten zusätzlichen Transistor, die in dieser Reihenfolge elektrisch in Reihe zwischen einem der zweiten Knoten und einem zusätzlichen Knoten zum Anlegen eines der zweiten Pegel geschaltet sind, wobei der zweite zusätzliche Transistor seine Steuerung mit einem Knoten zum Liefern der ersten Spannung gekoppelt hat;
- einen Verbindungsknoten zwischen dem ersten und dem zweiten zusätzlichen Transistor, der mit einem Steueranschluss des ersten Transistors gekoppelt ist, der von der ersten Schaltung gesteuert wird, wobei der erste zusätzliche Transistor in einen Zustand gesteuert wird, der das Inverse des Zustands des dritten zusätzlichen Transistors ist; und
- eine zweite Transistorsteuerschaltung Folgendes aufweist:
- einen vierten, einen fünften und einen sechsten zusätzlichen Transistor, die in dieser Reihenfolge elektrisch in Reihe zwischen dem einen der zweiten Knoten und dem anderen der zweiten Knoten geschaltet sind, wobei der fünfte zusätzliche Transistor seine Steuerung mit einem Knoten zum Liefern der zweiten Spannung gekoppelt hat;
- einen Verbindungsknoten zwischen dem fünften und dem sechsten zusätzlichen Transistor, der mit einem Steueranschluss des zweiten Transistors gekoppelt ist, der von der zweiten Schaltung gesteuert wird, wobei der vierte zusätzliche Transistor in einen Zustand gesteuert wird, der das Inverse des Zustands des sechsten zusätzlichen Transistors ist.

2. Eine Einrichtung (200, 400), die konfiguriert ist zum Bereitstellen eines Ausgangspotentialpegels aus zwei ersten Pegeln entsprechend einem Eingangspegel aus zwei zweiten Pegeln, wobei die Einrichtung Folgendes aufweisend:
- einen ersten (201) und einen zweiten (202) Transistor, die durch einen ersten Knoten (210) zum Bereitstellen des Ausgangspegels miteinander verbunden sind und elektrisch in Reihe zwischen zweiten Knoten (VGH, VGL) zum Anlegen der ersten Pegel geschaltet sind;
- einen ersten Spannungsgenerator (230), der von einem der zweiten Knoten (VGH) gespeist wird und konfiguriert ist zum Bereitstellen einer ersten Gleichspannung (V1), die eine Obergrenze für die Steuerspannung des ersten Transistors definiert; und
- einen zweiten Spannungsgenerator (240), der durch einen Wert gesteuert wird, der für die erste Spannung repräsentativ ist, zwischen den zweiten Knoten versorgt wird und konfiguriert ist zum Bereitstellen einer zweiten Gleichspannung (V2), die eine Obergrenze für die Steuerspannung des zweiten Transistors definiert,
wobei:
- der erste Generator (230) einen dritten Transistor (233) aufweist, der konfiguriert ist zum Leiten eines ersten Stroms (IB1) zum Versorgen des ersten Generators; und
- der zweite Generator (240) einen vierten Transistor (244) aufweist, der mit dem dritten Transistor einen Stromspiegel bildet und konfiguriert ist zum Leiten eines zweiten Stroms (IB2) zum Versorgen des zweiten Generators, wobei die Einrichtung ferner Folgendes aufweist:
- eine erste Transistorsteuerschaltung, die Folgendes aufweist:
- einen ersten, einen zweiten und einen dritten zusätzlichen Transistor, die in dieser Reihenfolge elektrisch in Reihe zwischen dem einen der zweiten Knoten und einem zusätzlichen Knoten zum Anlegen eines der zweiten Knoten und einem zusätzlichen Knoten zum Anlegen einer der zweiten Pegel geschaltet sind, wobei der zweite zusätzliche Transistor seine Steuerung mit einem Knoten zum Liefern der ersten Spannung gekoppelt hat;
- einen Verbindungsknoten zwischen dem ersten und dem zweiten zusätzlichen Transistor, der mit einem Steueranschluss des ersten Transistors gekoppelt ist, der von der ersten Schaltung gesteuert wird, wobei der erste zusätzliche Transistor in einen Zustand gesteuert wird, der das Inverse des Zustands des dritten zusätzlichen Transistors ist; und eine zweite Transistorsteuerschaltung, die Folgendes aufweist:
- einen vierten, fünften und sechsten zusätzlichen Transistor, die in dieser Reihenfolge elektrisch in Reihe zwischen dem einen der zweiten Knoten und dem anderen der zweiten Knoten geschaltet sind, wobei der fünfte zusätzliche Transistor seine Steuerung mit einem Knoten zum Liefern der zweiten Spannung gekoppelt hat;
einen Verbindungsknoten zwischen dem fünften und dem sechsten zusätzlichen Transistor, der mit einem Steueranschluss des zweiten Transistors gekoppelt ist, der von der zweiten Schaltung gesteuert wird, wobei der vierte zusätzliche Transistor in einen Zustand gesteuert wird, der das Inverse des Zustands des sechsten zusätzlichen Transistors ist.

3. Das Verfahren nach Anspruch 1 oder die Einrichtung nach Anspruch 2, wobei:
- ein erstes Signal (SVGH; SVGH1), das einen gewünschten Zustand des zweiten Transistors (202) repräsentiert, auf das Potential des einen der zweiten Knoten (VGH) bezogen ist; und
- vorzugsweise das erste Signal (SVGH; SVGH1) aus einem zweiten Signal (SGND; SGND1) erzeugt wird, das einen gewünschten Zustand des ersten Transistors (201) repräsentiert und auf ein Referenzpotential zu den zweiten Pegeln bezogen ist.

4. Das Verfahren nach Anspruch 1 oder 3 oder die Einrichtung nach Anspruch 2 oder 3, wobei:
- der erste Generator (230) elektrisch in Reihe mit dem dritten Transistor (233) zwischen dem einen der zweiten Knoten (VGH) und einem dritten Knoten (235) zum Liefern der ersten Spannung (V1) ein erstes Element (236) mit einem vordefinierten Spannungsabfall beim Durchgang des ersten Stroms (IB1) aufweist, wobei das erste Element vorzugsweise eine Diode aufweist; und
- der zweite Generator (240) ein zweites Element (247) mit einem vordefinierten Spannungsabfall beim Durchgang des zweiten Stroms (IB2) aufweist, das einen vierten Knoten mit dem anderen der zweiten Knoten (VGL) koppelt und vorzugsweise einen fünften Transistor (249) und eine Diode (248) aufweist, die elektrisch in Reihe geschaltet sind.

5. Das Verfahren nach einem der Ansprüche 1, 3 oder 4 oder die Einrichtung nach einem der Ansprüche 2 bis 4, wobei eine Schaltung (310) zum Steuern des ersten Transistors (201) aus der oder einer der ersten Schaltungen (310) ausgebildet ist und/oder eine Schaltung (320) zum Steuern des zweiten Transistors (202) aus der oder einer der zweiten Schaltungen (320) ausgebildet ist.

6. Das Verfahren oder die Einrichtung nach Anspruch 5 in Abhängigkeit von Anspruch 3, wobei das erste Signal (SVGH) den vierten zusätzlichen Transistor (324) der Schaltung (320) zum Steuern des zweiten Transistors (202) steuert.

7. Das Verfahren oder die Einrichtung nach Anspruch 5 in Abhängigkeit von Anspruch 3 oder nach Anspruch 6, wobei das erste Signal (SVGH) von einer weiteren der ersten Schaltungen (330) erzeugt wird, deren dritter zusätzlicher Transistor (333) durch das zweite Signal (SGND) gesteuert wird.

8. Das Verfahren oder die Einrichtung nach einem der Ansprüche 5 bis 7 in Abhängigkeit von Anspruch 3, wobei:
- der dritte zusätzliche Transistor (313) der Schaltung (310) zum Steuern des ersten Transistors (201) durch ein Signal (SGND1) gesteuert wird, das das inverse des zweiten Signals (SGND) ist; und/oder
- der vierte zusätzliche Transistor (324) der Schaltung (320) zum Steuern des zweiten Transistors (202) durch ein Signal (SVGH) gesteuert wird, das das inverse des ersten Signals (SVGH1) ist.

9. Das Verfahren oder die Einrichtung nach Anspruch 8, wobei:
- das Signal (SVGH), das das inverse Signal des ersten Signals (SVGH1) ist, von einer weiteren der ersten Schaltungen (330) geliefert wird, deren dritter zusätzlicher Transistor (333) durch das Signal (SGND) gesteuert wird, das das inverse Signal des zweiten Signals (SGND1) ist, und deren erster zusätzlicher Transistor (331) durch die weitere der ersten Schaltungen (340) gesteuert wird; und
- der erste zusätzliche Transistor (341) der anderen der ersten Schaltungen (340) durch die weitere der ersten Schaltungen gesteuert wird.

10. Das Verfahren oder die Einrichtung nach Anspruch 8 oder 9, wobei der vierte zusätzliche Transistor (354) einer weiteren der zweiten Schaltungen (350) durch das Signal (SVGH1) gesteuert wird, das das inverse des ersten Signals (SVGH) ist, und der sechste Transistor (326) der Einrichtung zum Steuern des zweiten Schalters (320) durch die weitere der zweiten Schaltungen gesteuert wird.

11. Das Verfahren oder die Einrichtung nach Anspruch 10, wobei:
- eine weitere der zweiten Schaltungen (360) seinen vierten zusätzlichen Transistor (364) durch das erste Signal (SVGH) gesteuert hat und seinen sechsten zusätzlichen Transistor (366) durch die andere der zweiten Schaltungen (350) gesteuert hat; und
- der sechste zusätzliche Transistor der anderen der zweiten Schaltungen durch die weitere der zweiten Schaltungen gesteuert wird.

12. Das Verfahren nach einem der Ansprüche 1 und 3 bis **11** oder die Einrichtung nach einem der Ansprüche 2 bis **11,** wobei ein Wert der ersten Gleichspannung (V1) nach dem Pegel eines logischen Freigabe-/Sperrsignals (EN; DIS) ausgewählt wird, und zwar zwischen einem Wert, der niedriger ist als eine Spannungsschwelle zum Steuern des ersten Transistors (201), und einem Wert, der größer ist als die Spannungsschwelle.

13. Das Verfahren nach einem der Ansprüche 1 und 3 bis 12 oder die Einrichtung nach einem der Ansprüche 2 bis 12, wobei der Ausgangspotentialpegel einen Bildschirm, vorzugsweise vom OLED-Typ, steuert.

## Claims

1. Method of delivery of an output potential level among two first levels according to an input level among two second levels, comprising:
- the delivery of the output level by a first node (210) connecting together first (201) and second (202) transistors electrically in series between two second nodes (VGH, VGL) of application of the first levels;
- the delivery, by a first voltage generator (230) powered by one of the second nodes (VGH), of a first DC voltage (V1) defining a high limit for the control voltage of the first transistor; and
- the delivery, by a second voltage generator (240) controlled by a value representative of the first voltage and powered between the second nodes, of a second DC voltage (V2) defining a high limit for the control voltage of the second transistor,
wherein :
- the first generation (230) comprises a third transistor (233) configured to conduct a first current (IB1) for powering the first generator; and
- the second generator (240) comprises a fourth transistor (244) forming a current mirror with the third transistor and configured to conduct a second current (IB2) for powering the second generator;
- a first transistor control circuit comprises:
- first, second, and third additional transistors electrically in series in this order between one of the second nodes and an additional node of application of one of the second levels, the second additional transistor having its control coupled to a node for delivering the first voltage;
- a connection node between the first and second additional transistors, coupled to a control terminal of the first transistor controlled by the first circuit, the first additional transistor being controlled to a state which is the inverse of the state of the third additional transistor; and
- a second transistor control circuit comprises:
- fourth, fifth, and sixth additional transistors electrically in series in this order between said one of the second nodes and the other of the second nodes, the fifth additional transistor having its control coupled to a node for delivering the second voltage;
- a connection node between the fifth and sixth additional transistors coupled to a control terminal of the second transistor controlled by the second circuit, the fourth additional transistor being controlled to a state which is the inverse of the state of the sixth additional transistor.

2. Device (200, 400) configured to deliver an output potential level among two first levels according to an input level among two second levels, comprising:
- first (201) and second (202) transistors, connected together by a first node (210) for delivering the output level and electrically in series between second nodes (VGH, VGL) of application of the first levels;
- a first voltage generator (230) powered by one of the second nodes (VGH) and configured to deliver a first DC voltage (V1) defining a high limit for the control voltage of the first transistor; and
- a second voltage generator (240) controlled by a value representative of the first voltage, powered between the second nodes and configured to deliver a second DC voltage (V2) defining a high limit for the control voltage of the second transistor,
wherein:
- the first generator (230) comprises a third transistor (233) configured to conduct a first current (IB1) for powering the first generator; and
- the second generator (240) comprises a fourth transistor (244) forming a current mirror with the third transistor and configured to conduct a second current (IB2) for powering the second generator,
the device further comprising:
- a first transistor control circuit comprising:
- first, second, and third additional transistors electrically in series in this order between said one of the second nodes and an additional node of application of one of the second nodes and an additional node of application of one of the second levels, the second additional transistor having its control coupled to a node for delivering the first voltage;
- a connection node between the first and second additional transistors, coupled to a control terminal of the first transistor controlled by the first circuit, the first additional transistor being controlled to a state which is the inverse of the state of the third additional transistor; and
a second transistor control circuit comprising:
- fourth, fifth, and sixth additional transistors electrically in series in this order between said one of the second nodes and the other of the second nodes, the fifth additional transistor having its control coupled to a node of delivery of the second voltage;
a connection node between the fifth and sixth additional transistors coupled to a control terminal of the second transistor controlled by the second circuit, the fourth additional transistor being controlled to a state which is the inverse of the state of the sixth additional transistor.

3. Method according to claim 1 or device according to claim 2, wherein:
- a first signal (SVGH; SVGH1) representative of a desired state of the second transistor (202) is referenced to the potential of said one of the second nodes (VGH); and
- preferably, the first signal (SVGH; SVGH1) is generated from a second signal (SGND; SGND1) representative of a desired state of the first transistor (201) and referenced to a reference potential to the second levels.

4. Method according to claim 1 or 3 or device according to claim 2 or 3, wherein:
- the first generator (230) comprises, electrically in series with the third transistor (233) between said one of the second nodes (VGH) and a third node (235) for delivering the first voltage (V1), a first element (236) having a predefined voltage drop at the passage of the first current (IB1), the first element preferably comprising a diode; and
- the second generator (240) comprises a second element (247) having a predefined voltage drop at the passage of the second current (IB2), coupling a fourth node to the other of the second nodes (VGL), and preferably comprising a fifth transistor (249) and a diode (248) electrically in series.

5. Method according to any of claim 1, 3 or 4, or device according to any of claims 2 to 4, wherein a circuit (310) for controlling the first transistor (201) is formed of the or of one of the first circuits (310) and/or a circuit (320) for controlling the second transistor (202) is formed of the or of one of the second circuits (320).

6. Method or device according to claim 5 as dependent on claim 3, wherein the first signal (SVGH) controls the fourth additional transistor (324) of the circuit (320) for controlling the second transistor (202).

7. Method or device according to claim 5 as dependent on claim 3 or according to claim 6, wherein the first signal (SVGH) is generated by another of the first circuits (330) having its third additional transistor (333) controlled by the second signal (SGND).

8. Method or device according to any of claims 5 to 7 as dependent on claim 3, wherein:
- the third additional transistor (313) of the circuit (310) for controlling the first transistor (201) is controlled by a signal (SGND1) which is the inverse of the second signal (SGND); and/or
- the fourth additional transistor (324) of the circuit (320) for controlling the second transistor (202) is controlled by a signal (SVGH) which is the inverse of the first signal (SVGH1).

9. Method or device according to claim 8, wherein:
- the signal (SVGH) which is the inverse of the first signal (SVGH1) is delivered by still another of the first circuits (330) having its third additional transistor (333) controlled by the signal (SGND) which is the inverse of the second signal (SGND1) and its first additional transistor (331) controlled by said another of the first circuits (340); and
- the first additional transistor (341) of said another of the first circuits (340) is controlled by said still another of the first circuits.

10. Method or device according to claim 8 or 9, wherein the fourth additional transistor (354) of another of the second circuits (350) is controlled by the signal (SVGH1) which is the inverse of the first signal (SVGH), and the sixth transistor (326) of the circuit for controlling the second switch (320) is controlled by said another of the second circuits.

11. Method or device according to claim 10, wherein:
- still another of the second circuits (360) has its fourth additional transistor (364) controlled by the first signal (SVGH) and has its sixth additional transistor (366) controlled by said another of the second circuits (350); and
- the sixth additional transistor of said another of the second circuits being controlled by said still another of the second circuits.

12. Method according to any of claims 1 and 3 to 11, or device according to any of claims 2 to 11, wherein a value of the first DC voltage (V1) is selected according to the level of a logic enable/disable signal (EN; DIS) between a value lower than a voltage threshold for controlling the first transistor (201) and a value greater than the voltage threshold.

13. Method according to any of claims 1 and 3 to 12, or device according to any of claims 2 to 12, wherein the output potential level controls a display screen, preferably of OLED type.
